Europäisches Patentamt

European Patent Office

Office européen des brevets

(19)

(11) Veröffentlichungsnummer: **0 288 704 B1**

(12) **EUROPÄISCHE PATENTSCHRIFT**

(45) Veröffentlichungstag der Patentschrift: **20.01.93**

(51) Int. Cl.5: **G01R 27/26**, G01D 5/20

(21) Anmeldenummer: **88103934.1**

(22) Anmeldetag: **12.03.88**

(54) **Einrichtung zur Messung einer Induktivität.**

(30) Priorität: **29.04.87 DE 3714282**
**04.03.88 DE 3807015**

(43) Veröffentlichungstag der Anmeldung:
**02.11.88 Patentblatt 88/44**

(45) Bekanntmachung des Hinweises auf die
Patenterteilung:
**20.01.93 Patentblatt 93/03**

(84) Benannte Vertragsstaaten:
**DE FR GB IT NL SE**

(56) Entgegenhaltungen:
**EP-A- 0 194 493        EP-A- 0 207 218**
**DE-A- 3 210 890        DE-A- 3 342 378**
**DE-A- 3 343 885        DE-A- 3 526 560**
**DE-B- 1 093 904**

**IEEE TRANSACTIONS ON MAGNETICS, Band
MAG-22, Nr. 2, März 1986, Seiten 118-123,
IEEE, New York, US; R.L. MARESCA: "A general method for designing low-temperature
drift, high-bandwidth, variable-reluctance
position sensors"**

**PATENT ABSTRACTS OF JAPAN, Band 8, Nr.
72 (P-265)[1509], 4. April 1984; & JP-A-58 219
409**

(73) Patentinhaber: **WABCO Westinghouse Fahrzeugbremsen GmbH
Am Lindener Hafen 21 Postfach 91 12 80
W-3000 Hannover 91(DE)**

(72) Erfinder: **Charton, René, Dipl.-Ing.
Rudolfstrasse 1
W-3008 Garbsen 4(DE)**
Erfinder: **Kleen, Berend, Dipl.-Ing.
Hagenstrasse 26
W-3000 Hannover 1(DE)**

(74) Vertreter: **Schrödter, Manfred
WABCO Westinghouse Fahrzeugbremsen
GmbH Am Lindener Hafen 21 Postfach 91 12
80
W-3000 Hannover 91(DE)**

## Beschreibung

Die Erfindung bezieht sich auf eine Einrichtung zur Messung einer Induktivität gemäß dem Oberbegriff des Patentanspruchs 1.

Eine derartige Induktivitätsmessung ist beispielsweise erforderlich bei der Messung von Wegen mit einem induktiven Wegsensor. Bei solchen Wegsensoren ist ein Eisenkern in einer Spule verschiebbar gelagert. Je nach Eintauchtiefe des Kerns verändert sich der Wert der Induktivität der Spule. Diese ist somit ein Maß für den Weg des Eisenkerns.

Das Dokument DE-B-1093904 zeigt eine Einrichtung zur Messung einer Induktivität, wobei die Brennzeit einer Glimmentladung beim Entladen eines Induktors gemessen wird. Die Brennzeit, die Brennspannung der Glimmentladung und der gemessene Wert des Stroms vor dem Öffnen des Versorgungskreises des Induktors genügen, um die Induktivität des Induktors zu berechnen.

Zur Messung bzw. zur Auswertung der Induktivität von induktiven Sensoren sind elektronische Schaltungen bekannt, die nach verschiedenen Meßprinzipien arbeiten. So sind beispielsweise aus der DE-A-33 43 885 und der DE-A-35 19 978 Ansteuerschaltungen für einen induktiven Sensor bekannt, bei denen die Spule mit einem Spannungssprung beaufschlagt wird. Der Strom in der Spule steigt daraufhin von Null auf einen Wert an, der durch eine Strombegrenzung vorgegeben ist. Die Zeit vom Beginn des Stromanstiegs bis zum Ansprechen der Strombegrenzung wird mit Hilfe eines Mikrocomputers gemessen und ist ein Maß für die Induktivität bzw. die Position des Eisenkerns.

Nachteilig bei den aus der DE-A-33 43 885 und der DE-A-35 19 978 bekannten Schaltungen ist, daß bei einer Erhöhung der Umgebungstemperatur des Sensors sowohl der Wicklungswiderstand der Spule als auch die Permeabilität des Eisenkerns erhöht werden. Beide Faktoren bewirken aber additiv eine Verlängerung der Aufladezeit der Induktivität und damit einen Meßfehler bei der Wegmessung. Ein solcher Meßfehler fällt bei einer Anwendung des Wegsensors in einem Kraftfahrzeug, wo Umgebungstemperaturen von -40° bis +80° auftreten können, besonders ins Gewicht.

Es sind zwar Beschaltungen der Sensorspule mit einem NTC-Widerstandsnetzwerk bekannt (DE-A-35 26 560), durch das die Temperaturabhängigkeit kompensiert werden kann. Ein solches Widerstandsnetzwerk bedeutet jedoch einen zusätzlichen Kostenfaktor, der sich besonders bei Massenartikeln, wie sie für den Kraftfahrzeugbereich benötigt werden, besonders ungünstig auswirkt.

Der Erfindung liegt die Aufgabe zugrunde, eine Einrichtung zur Messung einer Induktivität anzugeben, wobei eine unerwünschte Temperaturabhängigkeit des Meßwertes nicht oder jedenfalls nur in stark abgeschwächter Form auftritt.

Diese Aufgabe wird durch die im Patentanspruch 1 enthaltene Erfindung gelöst. Die abhängigen Ansprüche enthalten zweckmäßige Ausgestaltungen der Erfindung.

Die Erfindung wird im folgenden anhand einer Zeichnung näher erläutert. Die Zeichnung zeigt in der

**Fig. 1** eine Prinzipschaltung zur Erläuterung des Meßverfahrens,

**Fig. 2** ein Diagramm des Spulenstromes über der Zeit,

**Fig. 3** ein Diagramm der Spulenspannung über der Zeit,

**Fig. 4** ein Diagramm der Ausgangsspannung über der Zeit,

**Fig. 5** ein weiteres Diagramm des Spulenstromes über der Zeit mit Berücksichtigung des Temperatureinflusses,

**Fig. 6** eine Meßschaltung in ausführlicher Darstellung,

**Fig. 7** einen induktiven Wegsensor im Längsschnitt.

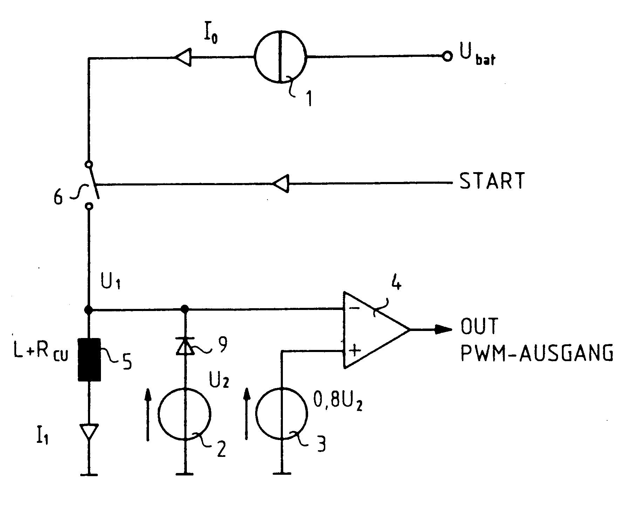

Gemäß Fig. 1 fließt im Ruhezustand der Schaltung ein stationärer Strom $I_1$ durch einen zunächst geschlossenen Schalter (6) und eine Spule (5). Die Spule (5) hat eine Induktivität L und einen Ohmschen Widerstand $R_{cu}$. Der Strom $I_1$ wird durch eine Spannungsquelle $U_{bat}$ (z.B. 24 V) erzeugt und mittels einer Konstantstromquelle (1) auf einen Konstantwert $I_0$ (z.B. 50 mA) begrenzt.

Am nicht geerdeten Ende der Spule (5) fällt dann die Spannung $U_1$ ab. Der stationäre Wert von $U_1$ ist $U_1 = I_0 \cdot R_{cu}$ (z.B. 3,5 V). Die stationär in der Spule (5) verbrauchte Leistung wäre damit 50 mA $\cdot$ 3,5 V = 175 mW.

Der Spule (5) ist eine Spannungsquelle (2) der Größe $U_2$ (z.B. 10 V) und eine Diode (9) parallel geschaltet. Ebenfalls parallel geschaltet ist eine zweite Spannungsquelle (3) der Größe 0,8 $U_2$ und ein Operationsverstärker (4) (Komparator).

Eine Wegmessung beginnt mit dem Öffnen des Schalters (6) zum Zeitpunkt $t_1$. Das Startsignal (START) hierzu kann z.B. durch einen Mikrocomputer (nicht dargestellt) in regelmäßigen Abständen erzeugt werden. Der Strom $I_1$ durch die Spule (5) fließt nach dem Öffnen des Schalters (6) zunächst durch die Spannungsquelle (2) und die Diode (9) weiter. Durch die Spannungsquelle (2) wird die Spulenspannung begrenzt auf einen Wert von $U_2$ - (z.B. 10 Volt).

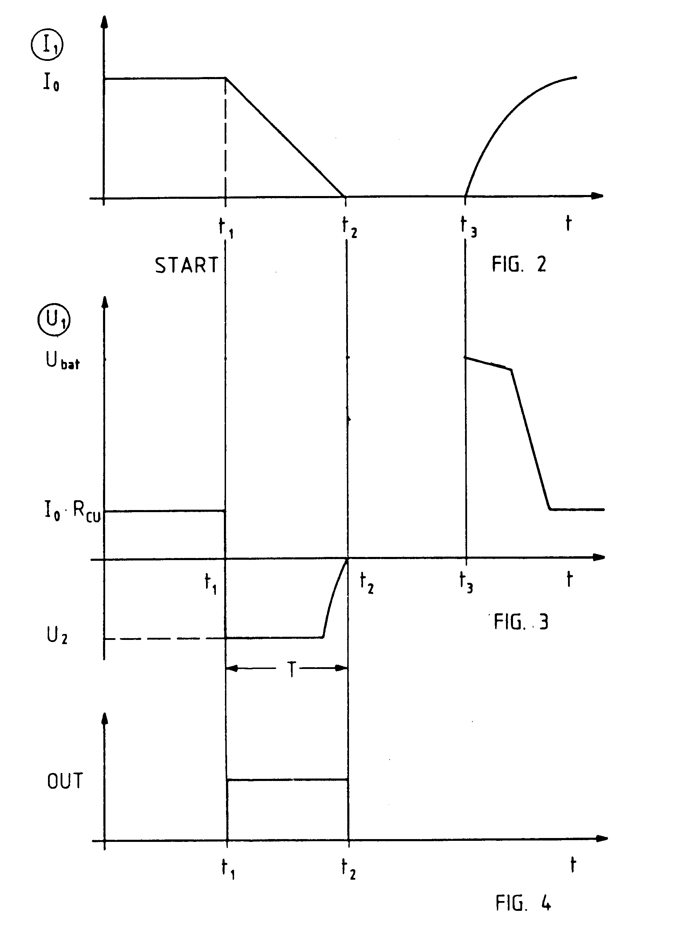

Der Strom $I_1$ ist im Zeitpunkt $t_2$ auf Null abgefallen (vergl. Fig. 2 und 3). Hierdurch wird die Diode (9) hochohmig und trennt so die Spule (5) von der Spannungsquelle (2) ab. Damit sinkt die Spannung $U_1$ auf Null Volt.

Zum Zeitpunkt $t_3$ wird die Schaltung durch Wiedereinschaltung des Stromes $I_1$ mit dem Schalter (6) wieder aktiviert. Bis der stationäre Wert $I_0$ wieder erreicht ist, fällt an der Spule (5) eine erhöhte Spannung ab, welche mit dem Wert $U_{bat}$ beginnt.

Die Abklingzeit T des Spulenstroms $I_1$ ist unter Voraussetzung, daß die Induktivität L ideal ist,

$$T = I_o \cdot \frac{L}{U_2}$$

Da $I_0$ und $U_2$ konstant sind, ist die Dauer der Abklingzeit T ein direktes Maß für die Induktivität L der Spule (5). Die Induktivität L steht wiederum in fester Beziehung zur Stellung des Eisenkerns in der Spule (5).

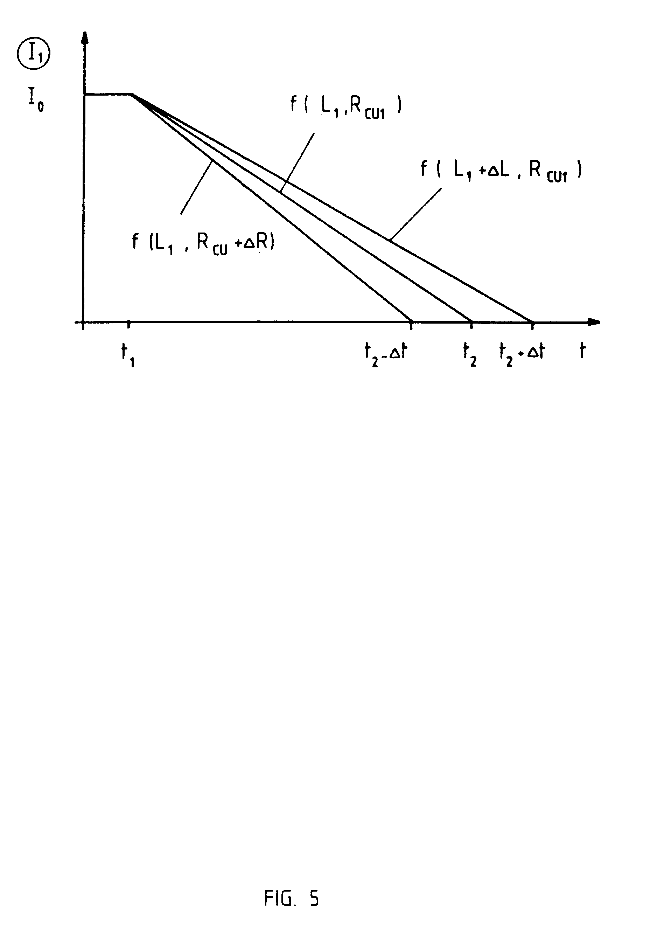

Der als Komparator geschaltete Operationsverstärker (4) schaltet durch, solange die Diode (9) niederohmig ist, d.h. von $t_1$ bis $t_2$ (siehe Fig. 4). Die Dauer des Ausgangssignals OUT ist also ein Maß für die Zeit T. Die eigentliche Messung des Wertes T sowie die Weiterverwertung kann durch einen (nicht dargestellten) Mikrocomputer erfolgen, der an dem Ausgang OUT bzw. PWM (Pulsweiten-Modulation) angeschlossen ist.

Die reale Induktivität L der Spule (5) ist mit einem Wicklungswiderstand $R_{cu}$ behaftet. An diesem entsteht ein Spannungsabfall, der sich in der Abklingphase des Stromes $I_1$ zur Spannung $U_2$ addiert, die Zeit T also verkleinert (Fig. 5). Erwärmt man den Sensor, so steigt der Wicklungswiderstand $R_{cu}$ der Spule (5) an und die Zeit T wird kürzer. Gleichzeitig steigt aber auch die Permeabilität des Eisenkreises, was zu einer Vergrößerung der Induktivität L und somit zu einer Verlängerung der Zeit T führt. Der Fehler, der durch den Temperaturgang des Wicklungswiderstandes $R_{cu}$ entsteht, wird also zum Teil durch den Fehler, der durch den Temperaturgang der Induktivität L entsteht, kompensiert. Eine externe Kompensation durch NTC-Widerstände ist daher nicht mehr notwendig.

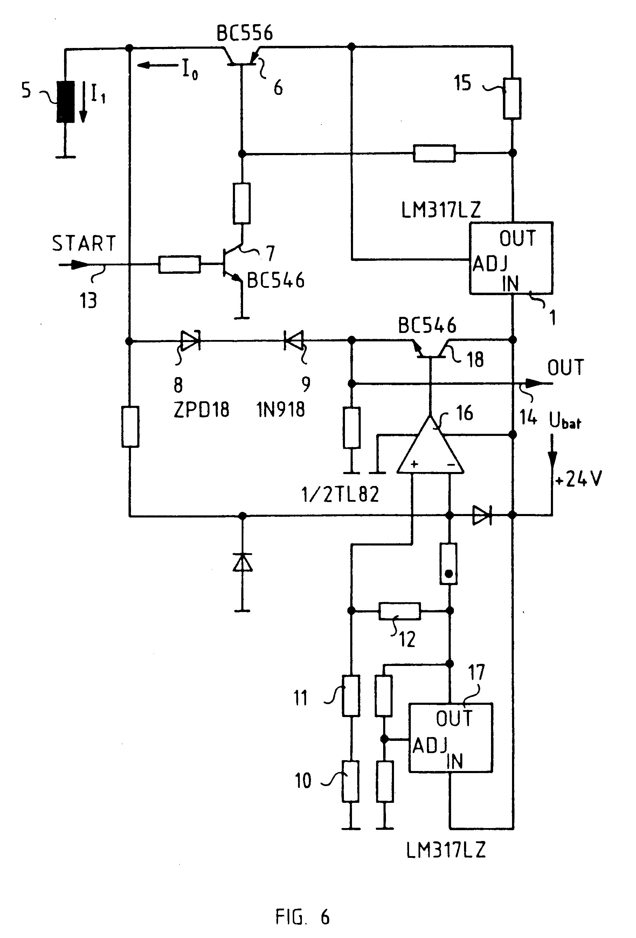

In der Fig. 6 ist eine real ausgeführte elektrische Schaltung dargestellt, die nach dem Prinzip der Erfindung bzw. der Prinzipschaltung nach der Fig. 1 arbeitet.

Als Strombegrenzung bzw. Konstantstromquelle (1) für den Spulenstrom $I_1$ dient eine integrierte Schaltung vom Typ LM317LZ (Fa. National Semiconductor). Als Schalter (6) dient ein PNP-Transistor (BC556). Dieser wird von einem weiteren Transistor (7) (BC546) angesteuert. Die negative Spulenspannung während der Abschaltung des Stromes $I_1$ wird auf den Wert $U_2$ begrenzt durch einen Operationsverstärker (16) (TL82 Fa. Texas Instruments). Die negative Abschaltspannung an der Spule (5) wird durch eine Zenerdiode (8) (ZPD18) auf das positive Niveau des Ausgangs des Operationsverstärkers (16) angehoben.

Der Eingang des Operationsverstärkers (16) wird durch einen Spannungsteiler (10, 11, 12) an die negative Abschaltspannung angepaßt. Hier wird keine Zenerdiode verwendet, um einen zusätzlichen Fehler durch dem Temperaturgang dieser Diode zu vermeiden.

Das Ausgangssignal des Operationsverstärkers (16) wird durch einen Transistor (18) (BL546) verstärkt. Die Diode (9) (1N918) trennt den Konstantstrom $I_o$ von der Meßschaltung.

Als weitere Spannungsquelle (3) dient eine integrierte Schaltung (17) vom Typ LM317LZ.

Das Startsignal für einen Meßvorgang erfolgt durch eine negative Spannung vom Eingang (13) (START). An der Kathode der Zenerdiode (8) bzw. am Ausgang (OUT) entsprechend Leitung (14) kann dann ein positiver Spannungsimpuls abgegriffen werden, der die Länge der Abklingzeit T hat.

Eine Abgleichmöglichkeit für den Spulenstrom $I_0$ ist durch Veränderung des Widerstandes (15) am Ausgang der Konstantstromquelle (1) gegeben. Ein Abgleich der Referenzspannung am positiven Eingang des Operationsverstärkers (16) ist durch eine Änderung des Spannungsteilers (10, 11, 12) am Eingang des Operationsverstärkers (16) möglich.

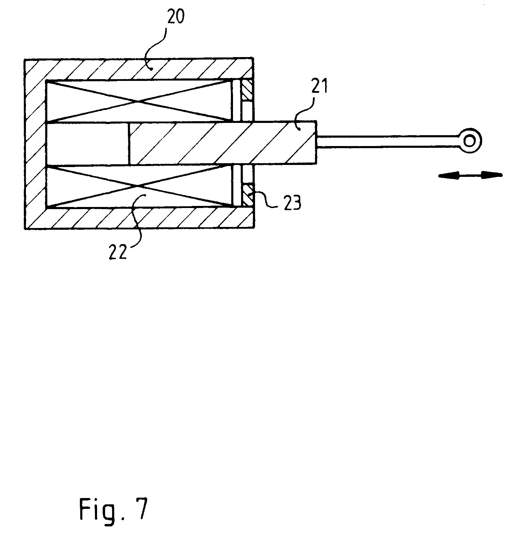

In der Fig. 7 ist schematisch im Längsschnitt ein für das Meßverfahren geeigneter Wegsensor dargestellt. Er besteht aus einem äußeren Jochtopf (20), einem verschiebbaren Kern (21) und einer im Jochtopf (20) angeordneten Wicklung (22). Je nach Position des Kernes (21) verändert sich die Induktivität des Sensors.

Bei einer Erhöhung der Umgebungstemperatur des Sensors erhöht sich auch der Ohmsche Widerstand der Wicklung. Dies bewirkt einen negativen Temperaturkoeffizienten, was bedeutet, daß sich die Entladezeit der Induktivität verkürzt (vergl. Fig. 5).

Einen umgekehrten Effekt auf die Entladezeit hat die durch erhöhte Temperatur vergrößerte Permeabilität der meisten Eisensorten. Hierdurch verlängert sich die Entladezeit (vergl. Fig. 5).

Es ist nun aber leider nicht möglich, durch Auswahl einer bestimmten Eisensorte den Einfluß des Wicklungswiderstandes genau zu kompensieren. Dies liegt daran, daß der Einfluß des Magnetkreises auf den Temperaturkoeffizienten stark abhängig ist von der Scherung des Magnetkreises, also von der Ankerposition. Bei ausgefahrenem Anker überwiegt der Einfluß der Luftstrecke im Innern der Spule. Bei eingefahrenem Anker ist dagegen ein Einfluß der Luftstrecke zu vernachlässigen.

Es ist daher grundsätzlich zweckmäßig, für den Magnetkreis ein Material mit möglichst geringem magnetischen Widerstand zu wählen. Dies kann durch Verwendung stark nickelhaltiger Eisenlegierungen erfolgen.

Wie bekannt ist, bewirkt neben der Permeabilität auch der Temperaturgang des Wirbelstromwiderstandes des Magnetkreises einen positiven Temperaturkoeffizienten. Dies liegt daran, daß der Widerstand für den Wirbelstrom mit steigender Temperatur ansteigt. Deshalb kann sich bei steigender Temperatur der Wirbelstrom nur in geringem Maße kompensierend auf den Wert der Induktivität auswirken. Dies ist der Grund dafür, daß sich die Entladezeit aufgrund des beschriebenen Wirbelstromverhaltens mit steigender Temperatur verlängert (vergl. Fig. 5).

Zur Kompensation des negativen Temperaturkoeffizienten des Wicklungswiderstandes ist eine Steuerung bzw. Auswahl des Wirbelstromwiderstandes des Magnetkreises deshalb besonders geeignet, weil dieser Effekt unabhängig von der Ankerposition ist.

Es ist deshalb zweckmäßig, für den Magnetkreis (20, 21) ein Material mit hohem Temperaturkoeffizienten des Wirbelstromwiderstandes vorzusehen. Wenn dabei gleichzeitig, wie oben beschrieben, für den Magnetkreis ein Material mit geringem magnetischen Widerstand benutzt wird, läßt sich über den gesamten Positionsbereich des Ankers (21) sowie auch über den gesamten Temperaturbereich der Umgebung des Sensors eine gute Temperaturkompensation erreichen, weil die Windungszahl und, nach der Erfindung, die Materialien von Magnetkreis und Wicklung so ausgewählt werden, daß sich die Temperaturkoeffizienten von Magnetkreis und Wicklung gegenseitig aufheben.

Eine weitere Möglichkeit zur Beeinflussung bzw. Vergrößerung des Wirbelstromwiderstandes ist die Anordnung eines separaten Kurzschlußringes (23). Dieser wird zweckmäßig um die Ankeröffnung des Jochtopfes (20) gelegt, da an dieser Stelle die Kupplung zwischen der Wicklung (22) und dem Kurzschlußring (23) unabhängig von der Ankerstellung ist.

Bei gegenseitigem Abgleich im o.g. Sinne kann auch hier durch den positiven Temperaturkoeffizienten des Wirbelstromwiderstandes des Kurzschlußringes der negative Temperaturkoeffizient des Wicklungswiderstandes unabhängig von der Ankerstellung kompensiert werden.

Durch die Anwendung der Erfindung bei einem in der Praxis ausgeführten Wegsensor ist es gelungen, den verbleibenden Temperaturfehler auf ±1% zu reduzieren.

## Patentansprüche

1. Einrichtung zur Messung einer Induktivität, insbesondere der Spule eines induktiven Wegsensors, mit einer Wicklung (22) und einem Magnetkreis (20, 21), mit folgenden Merkmalen:

a) Eine geregelte Konstantstromquelle (1), die durch einen Schalter (6) abschaltbar mit der Induktivität (5) verbunden ist,

b) eine Begrenzungseinrichtung (2, 9) für die Abschaltspannung $U_1$ der Induktivität (5), die parallel zur Induktivität (5) geschaltet ist,

c) eine Erkennungsschaltung (3, 4) zur Erfassung der Abschaltspannung $U_1$ der Induktivität (5),

d) die Materialien des Magnetkreises (20, 21) und der Wicklung (22) sind so ausgewählt, daß sich, um die Temperaturkompensation der Messung zu verbessern, die Wirkung des Temperaturkoeffizienten des Wirbelstromwiderstandes des Magnetmaterials und die Wirkung des Temperaturkoeffizienten des Wicklungswiderstandes gegeneinander aufheben.

2. Wegsensor mit einer Einrichtung nach Anspruch 1, dadurch gekennzeichnet, daß für den Magnetkreis (20, 21) ein Material mit hohem Temperaturkoeffizienten des Wirbelstromwiderstandes vorgesehen ist.

3. Wegsensor mit einer Einrichtung nach Anspruch 1 oder 2, dadurch gekennzeichnet, daß für den Magnetkreis (20, 21) ein Material mit geringem magnetischen Widerstand vorgesehen ist.

4. Wegsensor mit einer Einrichtung nach einem oder mehreren der Ansprüche 1 bis 3, dadurch gekennzeichnet, daß um die Ankeröffnung des Jochtopfes (20) ein Kurzschlußring (23) gelegt ist.

## Claims

1. An arrangement for the measurement of an inductance, in particular of the coil of an inductive displacement sensor, with a winding (22) and a magnetic circuit (20, 21), having the following features:

a) a controlled constant-current source (1), which is connected by a switch (6), so as to be switched off, to the inductance (5),

b) a limiting means (2, 9) for the transient voltage $U_1$ of the inductance (5) which is connected parallel to the inductance (5),

c) a recognition circuit (3, 4) for detecting the transient voltage $U_1$ of the inductance (5),

d) the materials of the magnetic circuit (20, 21) and the winding (22) are selected so that, in order to improve the temperature compensation of the measurement, the effect of the temperature coefficient of the eddy-current resistance of the magnetic material and the effect of the temperature coefficient of the winding resistance cancel each other out.

2. A displacement sensor with an arrangement according to claim 1, characterized in that a material with a high temperature coefficient of the eddy-current resistance is provided for the magnetic circuit (20, 21).

3. A displacement sensor with an arrangement according to claim 1 or 2, characterized in that a material with a low magnetic resistance is provided for the magnetic circuit (20, 21).

4. A displacement sensor with an arrangement according to one or more of claims 1 to 3, characterized in that a short-circuiting ring (23) is placed around the armature opening of the pot core (20).

**Revendications**

1. Dispositif pour mesurer une inductance, en particulier l'inductance de la bobine d'un capteur inductif de déplacement, possédant un enroulement (22) et un circuit magnétique (20, 21), dispositif qui présente les particularités suivantes:
   a) il comprend une source de courant constant (1) régulée, connectée à l'inductance (5) par une liaison susceptible d'être coupée par un interrupteur (6),
   b) il comprend un dispositif de limitation (2, 9) pour la tension de coupure $U_1$ de l'inductance (5), dispositif de limitation qui est monté en parallèle avec l'inductance (5),
   c) il comprend un circuit de détection (3, 4) pour déterminer la tension de coupure $U_1$ de l'inductance (5) et
   d) les matériaux du circuit magnétique (20, 21) et de l'enroulement (22) sont choisis, afin d'améliorer la compensation en température de la mesure, de manière que l'effet du coefficient de température de la résistance au courant de Foucault du matériau magnétique et l'effet du coefficient de température de la résistance ohmique de l'enroulement s'annulent mutuellement.

2. Capteur de déplacement comportant un dispositif selon la revendication 1, caractérisé en ce qu'un matériau à haut coefficient de température de la résistance au courant de Foucault est prévu pour le circuit magnétique (20, 21).

3. Capteur de déplacement comportant un dispositif selon la revendication 1 ou 2, caractérisé en ce qu'un matériau à faible résistance magnétique est prévu pour le circuit magnétique (20, 21).

4. Capteur de déplacement comportant un dispositif selon une ou plusieurs des revendications 1 à 3, caractérisé en ce qu'une bague de court-circuit (23) est disposée autour de l'ouverture prévue pour la traversée de l'armature dans le pot (20) formant la culasse.

$I_1$

$I_0$

$t_1$  $t_2$  $t_3$  $t$

START

FIG. 2

$U_1$

$U_{bat}$

$I_0 \cdot R_{cu}$

$t_1$  $t_2$  $t_3$  $t$

$U_2$

FIG. 3

T

OUT

$t_1$  $t_2$  $t$

FIG. 4

7

FIG. 5

FIG. 6

Fig. 7